# EUROPÄISCHE PATENTSCHRIFT

(11) **EP 1 297 577 B1**
(45) Veröffentlichungstag und Bekanntmachung des Hinweises auf die Patenterteilung: **03.09.2008**
(21) Anmeldenummer: 01911230.9
(22) Anmeldetag: 05.03.2001
(51) Int. Cl.: B32B 37/20, H01L 31/048, B32B 37/10

(54) **VERFAHREN ZUM HERSTELLEN EINES PHOTOVOLTAISCHEN DÜNNFILM-MODULS**
METHOD FOR PRODUCING A PHOTOVOLTAIC THIN FILM MODULE
PROCEDE DE PRODUCTION D'UN MODULE PHOTOVOLTAIQUE A COUCHES MINCES

(30) Priorität: 09.03.2000 AT 3872000; 05.10.2000 AT 16982000
(43) Veröffentlichungstag der Anmeldung: 02.04.2003
(73) Patentinhaber: ISOVOLTA AG, 2355 Wiener Neudorf (AT)
(72) Erfinder: PLESSING, Albert, 8302 Brunn 28 (AT)
(74) Vertreter: Dungler, Karin
(86) Internationale Anmeldenummer: PCT/AT2001/000061
(87) Internationale Veröffentlichungsnummer: WO 2001/067523

(56) Entgegenhaltungen:
- EP-A- 0 969 521
- US-A- 5 092 939
- US-A- 5 273 608

## Beschreibung

Die Erfindung betrifft ein Verfahren zum Herstellen eines photovoltaischen Dünnfilm-Moduls, welcher ein auf Trägermaterialien aufgebrachtes Dünnfilm-Solarsellensystem aufweist, das gegebenenfalls beidseitig von Einkapselungsmaterial-Verbunden umhüllt ist, wobei ein Kaschierschritt in einer Kaschierstation, bestehend aus einem Kalanderwalzenpaar erfolgt.

Photovoltaische Module dienen zum Erzeugen von elektrischer Energie aus Sonnenlicht. Die Energieerzeugung erfolgt dabei durch das Solarzellensystem, welches vorzugsweise durch Dünnfilmsolarzellen ausgebildet ist. Dünnfilmsolarzellen können aus verschiedenen Halbleitersystemen aufgebaut sein, wie CIGS (Kupfer-Indium-Gallium-Selenid), CTS (Kadmium-Tellurid-Sulfid), a-Si (amorphes Silizium) und anderen.

Diese dünnen Halbleitersysteme werden auf steifen Trägermaterialien wie Glas oder auf flexiblen Trägermaterialien, wie Polyimidfolien, Stahlbändern, Metallfolien und dergleichen aufgebracht.

Die Dünnfilmsolarzellen sind empfindlich gegenüber Umwelteinflüssen, wie Feuchtigkeit, Sauerstoff und UV-Licht. Sie müssen aber auch vor mechanischer Beschädigung geschützt und zusätzlich elektrisch isoliert werden. Deshalb ist es notwendig, die Dünnfilmsolarzellen beidseitig mit Einkapselungsmaterialien zu umhüllen. Als Einkapselungsmaterialien dienen beispielsweise eine oder mehrere Schichten aus Glas und/oder Kunststofffolien.

Folienverbunde, bestehend im Wesentlichen aus Polyvinylfluorid (PVF) und Polyethylenterephthalat (PETP), werden von der Anmelderin unter der Bezeichnung ICOSOLAR® vertrieben und in einem gemäß der WO-A1-94/29106 geoffenbarten Vakuumlaminierverfahren zur Herstellung von photovoltaischen Modulen eingesetzt. Ein weiteres Vakuumlaminierverfahren der Anmelderin wird in der EP-A1-969 521 beschrieben. Durch diese bekannten Verfahren werden zwar fotovoltaische Module bereitgestellt, in welchen das Solarzellensystem zufriedenstellend gegenüber Umwelteinflüssen geschützt ist, jedoch sind diese Verfahren selbst mit relativ hohem Energieverbrauch und langen Prozesszeiten verbunden, da die Laminierschritte einzeln, d.h. diskontinuierlich, durchgeführt werden. Des Weiteren eignet sich dieses diskontinuierliche Verfahren vorrangig für die Herstellung photovoltaischer Module mit erhöhter Steifigkeit, da zumindest eine Trägerschicht bzw. eine Einkapselungsschicht aus Glas besteht.

Kontinuierliche Verfahren zur Herstellung photovoltaischer Dünnfilm-Module mittels Kaschieren werden in der US-A-5,092,939 und der US-A-5,273,608 beschrieben, zeigen jedoch den Nachteil, dass die einzelnen Lagen des mitunter aufwendigen Schichtstapels für den photovoltaischen Modul auch einzeln aneinandergeführt werden müssen, was die Verfahrensführung **sowie Temperatureinstellung** relativ unübersichtlich und daher kompliziert aufgrund der hohen Anzahl an Materiallagen macht.

Aufgabe der vorliegenden Erfindung ist es daher, ein Verfahren zum Herstellen von **flexiblen** photovoltaischen **Dünnfilmmodulen** anzugeben, welches mit niedrigem Energieaufwand bei gleichzeitig reduzierter Verfahrensdauer leicht durchführbar ist und wobei dennoch photovoltaische Module mit zufriedenstellender Witterungsbeständigkeit für die Außenanwendung bereitgestellt werden.

Erfindungsgemäß wird ein Verfahren der eingangs genannten Art vorgeschlagen, welches dadurch gekennzeichnet ist, dass die Materialbahn für den Einkapselungsmaterial-Verbund, bestehend aus einer Barriereschicht und einer Siegelschicht, zusammen mit dem flexiblen Träger für das Dünnfilm-Solarzellensystem der Kaschierstation zugeführt wird, wobei die Materialbahnen in Heizstationen auf die Erweichungstemperatur der Siegelschicht erwärmt werden und den Kalanderwalzenspalt derart passieren, dass die Siegelschicht an das Dünnfilm-Solarzellensystem anschließt und dass durch den erhöhten Druck, bedingt durch den Kalanderwalzenanpressdruck und die erhöhte Temperatur, welche durch Erwärmen einer oder beider Walzen des Kalanderwalzenpaares auf zumindest die Erweichungstemperatur der Siegelschicht erzeugt wird, ein Verbund in Form des photovoltaischen Dünnfilm-Moduls gebildet wird.

Vorteilhafte Ausführungsformen des erfindungsgemäßen Verfahrens sind Gegenstand der Unteransprüche.

Die Erfindung wird im Folgenden anhand von Ausführungsbeispielen zur Durchführung der Erfindung sowie Vergleichsbeispielen näher erläutert. Zum besseren Verständnis dienen die Figurendarstellungen 1 bis 5.

Fig. 1 zeigt den Aufbau eines **aus der** EP-A-969 521 **bekannten** photovoltaischen Moduls 1 mit erhöhter Steifigkeit, welcher aus dem Dünnfilm-Solarzellensystem 2 auf dem steifen Trägermaterial 3 beispielsweise Glas, welches gleichzeitig als Einkapselungsmaterial dient, und einem zweiten Einkapselungsmaterial 4 besteht.

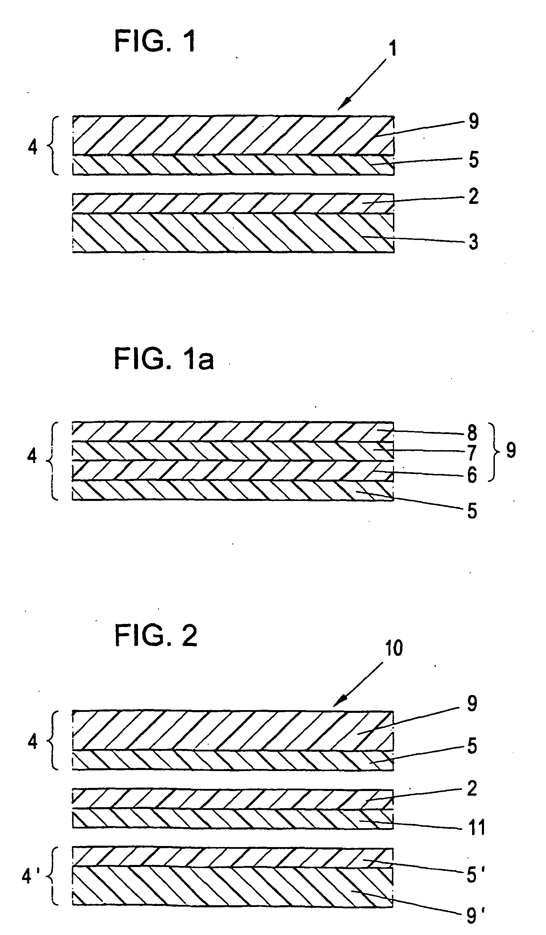

Das Einkapselungsmaterial 4 wird in Figur 1a dargestellt. Es besteht aus einer Kunststoff-Siegelschicht 5 und einer Barriereschicht 9, welche eine Trägerschicht 6 für eine aus der Dampfphase abgeschiedene anorganische Oxidschicht 7 und eine Witterungsschutzschicht 8 enthält.

Fig. 2 zeigt den Aufbau eines durch das erfindungsgemäße Verfahren hergestellten, flexiblen Dünnfilmmoduls 10. Die flexiblen Eigenschaften werden durch das flexible Trägermaterial 11 erzeugt.

Fig. 3 zeigt **die nicht erfindungsgemäße** Vorrichtung 12 zum Herstellen **des bekannten** steifen Dünnfilmmoduls 1.

Fig. 4 zeigt **die** Vorrichtung 20 zum **erfindungsgemäßen** Herstellen **des** flexiblen Dünnfilmmoduls 10.

Fig. 5 zeigt die Wasserdampfdurchlässigkeit mehrerer, mit einer SiOx-Beschichtung versehenen Trägerfolien, wobei unterschiedliche Kunststoffe als Trägerfolie eingesetzt und miteinander verglichen werden.

In einem ersten Verfahrensschritt wird das Einkapselungsmaterial 4 gemäß Fig. 1a, bestehend aus der Witterungsschutzschicht 8, der anorganischen Oxidschicht 7, der Trägerschicht 6 und der Kunststoff-Siegelschicht 5 gebildet.

Die Beispiele a) bis c) geben mögliche Varianten für die Auswahl der Stoffe in den jeweiligen Schichten wieder:

### Beispiel a):

Witterungsschutzschicht 8: Polyvinylfluorid (PVF) oder Polyvinylidenchlorid (PVDF) in Folienform,
Kleberschicht (nicht dargestellt): Polyurethan
Anorganische Oxidschicht 7: Siliziumoxid (SiOx) oder Aluminiumoxid (Al₂O₃)
Trägerschicht 6 für die anorganische Oxidschicht 7: Polyethylennaphthenat (PEN) oder Polyethylenterephthalat (PETP) sowie Koextrudate daraus in Form von Folien oder Folienverbunden
Kunststoff-Siegelschicht 5: Ethylenvinylacetat (EVA) oder Ionomere, Polymethylmethacrylat (PMMA), Polyurethan, Polyester oder Hot Melt

### Beispiel b):

Witterungsschutzschicht 8: Top-Coat-Beschichtung aus Polyurethan oder Polymethylmethacrylat (PMMA) und stabilisierter Polyethylenterephthalatfolie (PETP-Folie)
Kleberschicht (nicht dargestellt): Polyurethan
Anorganische Oxidschicht 7: Siliziumoxid (SiOx) oder Aluminiumoxid (Al₂O₃)
Trägerschicht 6 für die anorganische Oxidschicht 7: Polyethylennaphthenat (PEN) oder Polyethylenterephthalat (PETP) sowie Koextrudate daraus in Form von Folien oder Folienverbunden
Kunststoff-Siegelschicht 5: Ethylenvinylacetat (EVA) oder Ionomere, Polymethylmethacrylat (PMMA), Polyurethan, Polyester oder Hot Melt

### Beispiel c):

Witterungsschutzschicht 8: Fluorpolymere wie Ethylen-Tetrafluorethylen-Copolymer (ETFE), Polyvinylidenfluorid (PVDF), Polyvinylfluorid (PVF) oder andere Fluorpolymerfolien
Anorganische Oxidschicht 7: Siliziumoxid (SiOx) oder Aluminiumoxid (Al₂O₃)
Kunststoff-Siegelschicht 5: Ethylenvinylacetat (EVA) oder Ionomere, Polymethylmethacrylat (PMMA), Polyurethan, Polyester oder Hot Melt

In den Beispielen a) bis c) sind die Komponenten des Einkapselungsmaterials 4 angeführt, welche durch ihr Zusammenwirken das Dünnfilmsolarzellensystem 2 gegen Witterungseinflüsse und das Eindringen von Wasserdampf schützen.

Als Witterungsschutzschicht 8 werden insbesondere Fluorpolymere ausgewählt, welche das Dünnfilm-Solarzellensystem 2 gegen Witterungseinflüsse, wie beispielsweise UV-Strahlen, schützen.

Auf die Trägerschicht 6, welche beispielsweise aus PEN oder PET-PEN-Koextrudat besteht, wird die anorganische Oxidschicht 7 in einer Dicke von 30 bis 200nm durch Dampfabscheiden im Vakuum aufgebracht. Die Barriereschicht 9 bestehend aus Trägerschicht 6 und anorganischer Oxidschicht 7 schützt das Dünnfilm-Solarzellensystem 2 gegen das Eindringen von Wasserdampf.

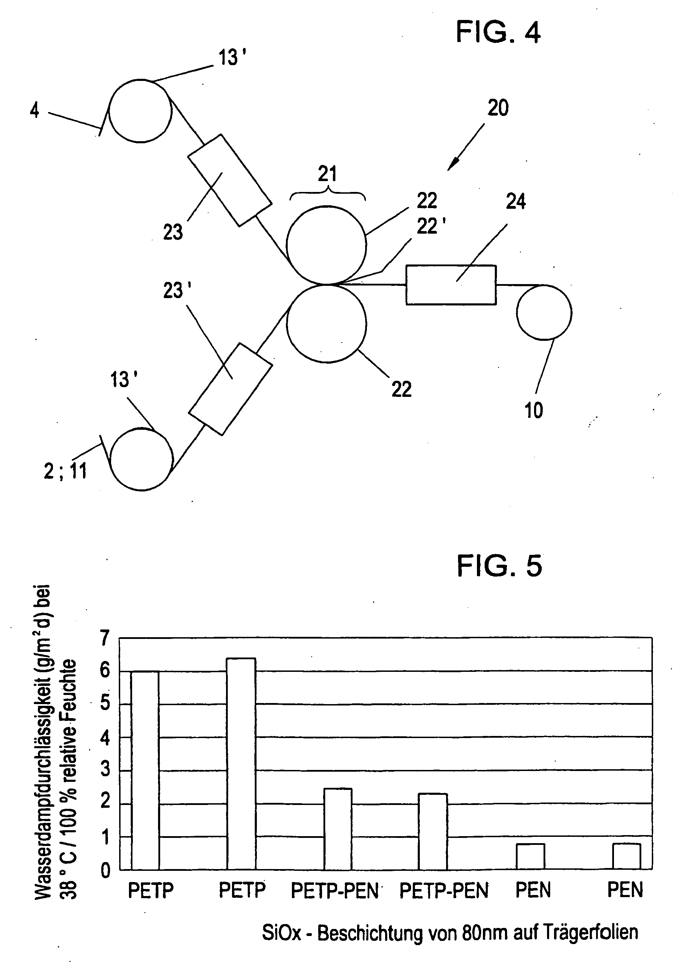

Der Schichtaufbau mit der anorganischen Oxidschicht 7 hat nämlich den Vorteil, dass die Wasserdampfdurchlässigkeit um den Faktor 10 niedriger ist als bei vergleichbaren anorganischen Oxidschichten, die auf PETP-Folien aufgebracht werden, was anhand von Fig. 5 gezeigt wird. Daraus ist zu ersehen, dass Polyethylenterephthalat (PETP) als Trägerschicht 6 zwar zufriedenstellende Werte zeigt, jedoch die Wasserdampfdurchlässigkeit ausgedrückt in g/m² d (Gramm pro Quadratmeter und Tag = day) durch den Zusatz von Polyethylennaphthenat (PEN) wesentlich reduziert werden kann. Dies wird in Fig. 5 anhand der Koextrudate PETP-PEN sowie anhand von reinem PEN anhand von je zwei Meßserien pro Kunststoff demonstriert.

Die im Einkapselungsmaterial 4 eingesetzte Siegelschicht 5 bewirkt durch ihre Klebeeigenschaften eine zusätzliche Schutzfunktion für das Dünnfilm-Solarzellensystem 2 da über die Siegelschicht die Verklebung des Dünnfilm-Solarzellensystems mit dem Einkapselungsmaterial 4 erfolgt.

Das Ausbilden des Einkapselungsmaterials 4 unter Verwendung der beispielhaften Varianten gemäß a) bis c) hinsichtlich Auswahl der Stoffe betreffend Witterungsschicht 8, Barriereschicht 7, Trägerschicht 6 und der Siegelschicht 5 erfolgt in einem an sich bekannten Leminierverfahren.

Unabhängig davon wird auf die Trägerschicht 6, beispielsweise eine Polyethylennaphthenatfolie (PETP-Folie), eine koextrudierte Polyethylenterephthalat/Polynaphthenatfolie (PETP-PEN-Folie) die Barriereschicht 7, beispielsweise eine Siliziumoxid (SiOx)-Schicht durch Abscheiden aus der Dampfphase aufgebracht.

An die Barriereschicht 7 wird in der Folge die Witterungsschicht 8, welche eine Kunststoff-Folie oder ein Kunststoff-Folienverbund sein kann, aufkaschiert. Ebenso wird die Siegelschicht 5, beispielsweise ein Polyurethankleber durch Kaschieren aufgebracht.

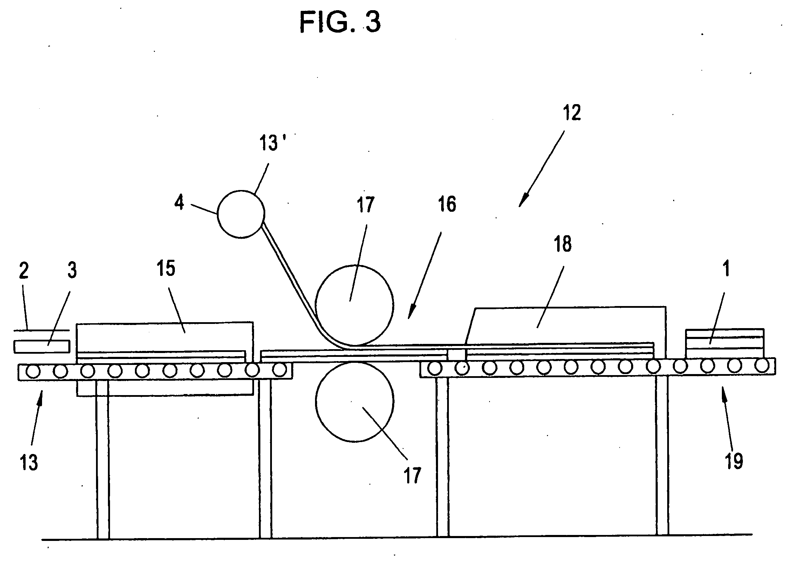

Das nunmehr gebildete Einkapselungsmaterial 4 wird auf der Vorratsrolle 13' in der Vorrichtung gemäß Fig. 3 gelagert. In der Beladestation 13 wird das Dünnfilm-Solarzellensystem 2 zusammen mit dem steifen Trägermaterial 3, beispielsweise Glas, auf ein Transportband (nicht dargestellt) aufgebracht und der Heizstation 15 zugeführt. Durch Regelungsvorrichtungen (nicht dargestellt) wird in der Heizstation das Dünnfilm-Solarzellensystem 2 zusammen mit dem starren Trägermaterial 3, beispielsweise dem Glasträger, auf die Erweichungstemperatur der Siegelschicht 5 im Einkapselungsmaterial 4 vorerwärmt. Sowohl das vorerwähnte Einkapselungsmaterial 4 als auch das auf Temperaturen von 70 bis 180°C vorerwärmte Dünnfilm-Solarzellensystem 2 zusammen mit dem Glasträger 3 werden nunmehr der Kaschierstation 16 in Form eines Kalanderwalzenpaares 17 zugeführt. Bedingt durch die erhöhte Temperatur in der Kaschierstation 16, welche vorzugsweise in einem Bereich von 70 bis 180° C liegt, sowie den durch die Kalanderwalzen 17 ausgeübten Druck, welcher vorzugsweise 80 bis 400 N/cm (Liniendruck) beträgt, wird durch Kaschieren der eingekapselte photovoltaische Modul 1 gemäß Figur 1 gebildet. Dieser wird in einen Härteofen (18) übergeführt, in welchem die Aushärtung, insbesondere der Siegelschicht 5, bei Temperaturen von etwa 120 bis 190° C, erfolgt. Nach entsprechendem Ablängen wird an der Entladestation 19 der endgefertigte Dünnfilm-Modul 1 entnommen.

**Die** erfindungsgemäße Verfahrensvariante wird anhand der Vorrichtung gemäß Figur 4 näher erläutert. Dabei wird, **wie oben erläutert,** das Einkapselungsmaterial 4 hergestellt und auf der Vorratsrolle 13' gelagert. Auf einer weiteren Vorratsrolle 13' wird das Dünnfilm-Solarzellensystem 2 zusammen mit einem flexiblen Träger 11 gelagert.

Der flexible Träger 11 kann eine Kunststoff-Folie oder ein Kunststoff-Folienverbund sein. Beispielsweise eignen sich Polyimid enthaltende Kunststoffe als flexible Träger.

In der Folge werden das Einkapselungsmaterial 4 bzw. das Dünnfilm-Solarzellensystem 2 zusammen mit dem flexiblen Träger 11 der Kaschierstation 21 zugeführt. Dabei werden beide Materialbahnen in den Heizstationen 23, 23' auf die Erweichungstemperatur der Siegelschicht 5, das heißt auf etwa 70 bis 180°C, erwärmt. Bei der Kaschierstation 21 handelt es sich gemäß Figur 4 beispielsweise um ein Kalanderwalzenpaar 22. Eine oder beide Walzen sind dabei zumindestens auf die Erweichungstemperatur der Siegelschicht 5 im Einkapselungsmaterial 4, vorzugsweise auf 70 bis 180°C, erwärmt. Dabei wird das vorerwärmte Einkapselungsmaterial 4 im Kalanderwalzenspalt 22' unmittelbar auf das Dünnfilm-Solarzellensystem 2 aufgebracht und bedingt durch einen Walzen-Anpreßdruck von etwa 80 bis 400 N/cm (Liniendruck) mit diesem verpresst. Anschließend wird der Verbund im Härteofen 24 bei Temperaturen von etwa 120 bis 190°C ausgehärtet. Durch diesen Kaschierschritt erfolgt eine Einkapselung des Dünnfilm-Solarzellensystems 2 sowie die Ausbildung eines photovoltaischen Dünnfilm-Moduls 10 gemäß Figur 2.

Durch Erhöhen der Anzahl an Vorratsrollen 13' wird der Einsatz eines zusätzlichen Einkapselungsmaterials 4' ermöglicht. Gemäß Figur 2 ist es denkbar, das Dünnfilm-Solarzellensystem 2 auch beidseitig zu umhüllen, sodass eine weitere Verbesserung hinsichtlich Witterungs- bzw. Barriereschutz für das Solarzellensystem 2 gewährleistet ist.

Zusammenfassend kann gesagt werden, dass durch das erfindungsgemäße Verfahren das Einkapselungsmaterial 4 sowie das Dünnfilm-Solarzellensystem 2 zusammen mit dem jeweiligen Träger derart durch Kaschieren miteinander verbunden und unter Druck und erhöhter Temperatur verpresst werden, dass ein witterungsbeständiger photovoltaischer Dünnfilmmodul in Form eines Verbundes ausgebildet wird. Das erfindungsgemäße Verfahren zeichnet sich gegenüber bekannten Verfahren durch niedrige Verfahrensdauer und Energiekosten aus. Zusätzlich wird in dem einfach durchführbaren Verfahren ein gegenüber UV-Licht, Wasserdampf und sonstigen Witterungseinflüssen beständiger photovoltaischer Dünnfilmmodul bereitgestellt. Durch Auswahl des Trägermaterials, beispielsweise in Form von Kunststofffolien bzw. Kunststoff-folienverbunden können dem photovoltaischen Modul zusätzlich flexible Eigenschaften verliehen werden.

Die durch das erfindungsgemäße Verfahren hergestellten photovoltaischen Dünnfilm-Module dienen zur elektrischen Energieerzeugung aus Sonnenlicht. Ihre Anwendungsmöglichkeiten sind vielfältig und reichen von Kleinenergieanlagen für Notrufsäulen oder Wohnmobile über in Gebäuden integrierten Dach- und Fassadenanlagen bis hin zu Großanlagen und Solarkraftwerken.

Bei den Anwendungen im Außenbereich hat es sich gezeigt, dass die Barrierewirkung der Einkapselungsmaterialien gegenüber Wasserdampf durch die aus der Dampfphase abgeschiedene Oxidschicht auf Trägerfolien aus PEN oder PETP-PEN-Koextrudaten zusätzlich erhöht wird.

## Patentansprüche

1. Verfahren zum Herstellen eines photovoltaischen Dünnfilm-Moduls (10), welcher ein auf Trägermaterialien (11) aufgebrachtes Dünnfilm-Solarzellensystem (2) aufweist, das gegebenenfalls beidseitig von Einkapselungsmaterial-Verbunden (4, 4') umhüllt ist, wobei ein Kaschierschritt in einer Kaschierstation (21), bestehend aus einem Kalanderwalzenpaar (22) erfolgt, **dadurch gekennzeichnet, dass** die Materialbahn für den Einkapselungsmaterial-Verbund (4, 4'), bestehend aus einer Barriereschicht (9, 9') und einer Siegelschicht (5), zusammen mit dem flexiblen Träger (11) für das Dünnfilm-Solarzellensystem (2) der Kaschierstation (21) zugeführt wird, wobei die Materialbahnen in den Heizstationen (23, 23') auf die Erweichungstemperatur der Siegelschicht erwärmt werden und den Kalanderwalzenspalt (22') derart passieren, dass die Siegelschicht (5) an das Dünnfilm-Solarzellensystem (2) anschließt und dass durch den erhöhten Druck, bedingt durch den Kalanderwalzenanpressdruck und die erhöhte Temperatur, welche durch Erwärmen einer oder beider Walzen des Kalanderwalzenpaares auf zumindest die Erweichungstemperatur der Siegelschicht (5) erzeugt wird, ein Verbund in Form des photovoltaischen Dünnfilm-Moduls (10) gebildet wird.

2. Verfahren nach Anspruch 1, **dadurch gekennzeichnet, dass** der gebildete photovoltaische Dünnfilm-Modul (10) zusätzlich ausgehärtet wird.

3. Verfahren nach Anspruch 1 oder 2, **dadurch gekennzeichnet, dass** als flexibles Trägermaterial (11) eines auf Basis von Kunststoff-Folien bzw. Kunststoff-Folienverbunden eingesetzt wird.

4. Verfahren nach Anspruch 1 oder 2, **dadurch gekennzeichnet, dass** als flexibles Trägermaterial (11) eines auf Basis von Metallfolien oder Stahlbändern eingesetzt wird.

5. Verfahren nach einem der Ansprüche 1 bis 4, **dadurch gekennzeichnet, dass** im Einkapselungsmaterial (4, 4') eine Barriereschicht (9) vorliegt, welche aus einer Witterungsschicht (8), einer anorganischen Oxidschicht (7) und einer für die anorganische Oxidschicht (7) vorgesehenen Trägerschicht (6) besteht.

6. Verfahren nach Anspruch 5, **dadurch gekennzeichnet, dass** in der Trägerschicht (6) Kunststoff-Folien bzw. Folienverbunde auf Basis von Polyethylennaphthenat (PEN) oder einem Koextrudat aus Polyethylen terephthalat (PETP) und Polyethylennaphthenat (PEN) eingesetzt werden.

7. Verfahren nach Anspruch 5 oder 6, **dadurch gekennzeichnet, dass** in der Barriereschicht (9) eine anorganische Oxidschicht (7), bestehend aus Aluminum- oder Siliziumoxid in einer Dicke von 30 bis 200 nm eingesetzt wird.

8. Verfahren nach einem der Ansprüche 1 bis 7, **dadurch gekennzeichnet, dass** die Siegelschicht (55) aus Hot-melt-Materialien, wie Polyamid oder thermoplastischen Elastomeren und/oder Ionomeren gebildet wird.

## Claims

1. A method for producing a photovoltaic thin film module (10), which has a thin film solar cell system (2) applied to carrier materials (11), the system (2) being optionally sheathed on both sides by composite encapsulating material (4, 4'), and a laminating step being effected in a laminating station (21), which consists of a pair of calendar rolls (22), **characterized in that** the material web for the composite encapsulating material (4, 4'), this consisting of a barrier layer (9, 9') and a sealing layer (5), together with the flexible carrier (11) for the thin film solar cell system (2), is fed to the laminating station (21), the material webs being heated up in the heating stations (23, 23') to the softening temperature of the sealing layer and passing the calendar roll gap (22') in such a way that the sealing layer (5) bonds onto the thin film solar cell system (2) and that by way of the increased pressure caused by the pressing force of the calendar rolls and the raised temperature which is achieved by heating up one or both rolls of the calendar roll pair to at least the softening temperature of the sealing layer (5), a bonded structure is provided in the form of the photovoltaic thin film module (10).

2. A method according to Claim 1, **characterized in that** the photovoltaic thin film module (10) formed is in addition hardened.

3. A method according to Claim 1 or 2, **characterized in that** a material based on plastics films or composite plastics films in used as flexible carrier material (11).

4. A method according to Claim 1 or 2, **characterized in that** a material based on metallic films or steel strips in used as flexible carrier material (11).

5. A method according to any of Claims 1 to 4, **characterized in that** a barrier layer (9) is provided in the encapsulating material (4. 4'), the barrier layer consisting a weather layer (8), an inorganic oxide layer (7) and a carrier layer (6) provided for the inorganic oxide layer (7).

6. A method according to Claim 5, **characterized in that** that plastics films or composite films based on polyethylene naphthenate (PEN) or a coextrudate of polyethylene terephthalate (PETP) and polyethylene naphthenate (PEN) are used in the carrier layer (6).

7. A method according to Claim 5 or 6, **characterized in that** an inorganic oxide layer (7), consisting of aluminium oxide or silicon oxide in a thickness of 30 to 200 nm in used in the barrier layer (9).

8. A method according to any of Claims 1 to 7, **characterized in that** the sealing layer (5) is formed from hot-melt materials, such as polyamide or thermoplastic elastomers and/or ionomers.

## Revendications

1. Procédé de fabrication d'un module photovoltaïque à couche mince (10), qui présente un système de piles solaires à couche mince (2) appliqué sur des matériaux de support (11), qui est éventuellement enveloppé, de part et d'autre, de composites de matériau d'encapsulage (4, 4'), dans lequel on procède à une étape de contre-collage dans un poste de contre-collage (21), constitué d'une paire de rouleaux de calandre (22), **caractérisé en ce que** la bande de matériau pour le composite de matériau d'encapsulage (4, 4'), constitué d'une couche barrière (9, 9') et d'une couche de scellage (5), conjointement avec le support flexible (11) pour le système de piles solaires à couche mince (2), est acheminée au poste de contre-collage (21), les bandes de matériau sont chauffées dans les postes de chauffage (23, 23') à la température de ramollissement de la couche de scellage et passent par l'intervalle entre les rouleaux de calandre (22') de manière à lier la couche de scellage (5) au système de piles solaires à couche mince (2) et à former un composite sous la forme du module photovoltaïque à couche mince (10) par l'augmentation de pression due à la pression d'application des rouleaux de calandre et l'augmentation de la température qui est générée par chauffage d'un ou des deux rouleaux de la paire de rouleaux de calandre à au moins la température de ramollissement de la couche de scellage (5).

2. Procédé selon la revendication 1, **caractérisé en ce que** l'on durcit encore le module photovoltaïque à couche mince (10) formé.

3. Procédé selon la revendication 1 ou 2, **caractérisé en ce que** l'on utilise, comme matériau de support flexible (11), un matériau à base de feuilles de matériau synthétique ou de stratifiés en matériau synthétique.

4. Procédé selon la revendication 1 ou 2, **caractérisé en ce que** l'on utilise, comme matériau de support flexible (11), un matériau à base de feuilles métalliques ou de bandes d'acier.

5. Procédé selon l'une quelconque des revendications 1 à 4, **caractérisé en ce que** le matériau d'encapsulage (4, 4') présente une couche barrière (9), qui est constituée d'une couche protectrice contre les intempéries (8), d'une couche d'oxyde inorganique (7) et d'une couche de support (6) prévue pour la couche d'oxyde inorganique (7).

6. Procédé selon la revendication 5, **caractérisé en ce que** l'on utilise, dans la couche de support (6), des feuilles de matériau synthétique ou des stratifiés à base de poly(naphténate d'éthylène) (PEN) ou d'un coextrudat de poly(téréphtalate d'éthylène) (PETP) et de poly(naphténate d'éthylène) (PEN).

7. Procédé selon la revendication 5 ou 6, **caractérisé en ce que** l'on utilise, dans la couche barrière (9), une couche d'oxyde inorganique (7), constituée d'oxyde d'aluminium ou d'oxyde de silicium d'une épaisseur de 30 à 200 nm.

8. Procédé selon l'une quelconque des revendications 1 à 7, **caractérisé en ce que** la couche de scellage (5) est formée de matériaux thermofusibles, comme le polyamide, ou d'élastomères et/ou d'ionomères thermoplastiques.
